(19) Europäisches Patentamt
European Patent Office
Office européen des brevets

(11) EP 2 770 336 A2

## (12) EUROPEAN PATENT APPLICATION

(43) Date of publication:
27.08.2014 Bulletin 2014/35

(51) Int Cl.:
$G01R\ 31/36$ (2006.01)

(21) Application number: 13168495.3

(22) Date of filing: 21.05.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 21.02.2013 US 201361767744 P

(71) Applicant: Samsung SDI Co., Ltd.
Yongin-si, Gyeonggi-do (KR)

(72) Inventor: Kim, Jong-Hoon
Gyeonggi-do (KR)

(74) Representative: Walaski, Jan Filip et al
Venner Shipley LLP
200 Aldersgate
London
EC1A 4HD (GB)

## (54) Apparatus for detecting faults in battery system

(57) An apparatus for detecting a fault in a battery system comprises a voltage detector arranged to receive a voltage signal v(t) from a battery system and to digitize the voltage signal to generate voltage data V[x], a discrete wavelet transformation unit arranged to perform discrete wavelet transformation on the voltage data to generate component data $D_j[x]$ and a fault diagnosing unit arranged to detect a fault in the battery system based on the component data.

FIG. 2

**Description**

The present invention relates to an apparatus for detecting faults in a battery system.

As problems such as the destruction of the environment, resource depletion, etc. have become more serious, interest in a system for storing energy and efficiently using the stored energy has increased. Also, there is increased interest in new generation energy which is energy that is generated without causing pollution. An energy storage system refers to a system which connects a battery system storing new generation energy and electric energy and an existing grid system to each other. Much research and development have been conducted in regard to recent environmental changes.

When the energy storage system operates, faults may occur in the battery system due to unexpected errors. These faults disable normal operation of the energy storage system and affect the grid system connected to the energy storage system. Although the unexpected errors may not be completely prevented, an apparatus for detecting and diagnosing faults in the energy storage system in real time to rapidly restore the energy storage system to a normal state is required.

According to the invention, there is provided an apparatus for detecting a fault in a battery system, the apparatus comprising a voltage detector arranged to receive a voltage signal v(t) from a battery system and to digitize the voltage signal to generate voltage data V[x], a discrete wavelet transformation unit arranged to perform discrete wavelet transformation on the voltage data to generate component data $D_j[x]$ and a fault diagnosing unit arranged to detect a fault in the battery system based on the component data.

The apparatus may further comprise a statistical processor arranged to process the component data to generate absolute values $|D_j[x]|$ of the component data.

The statistical processor may be arranged to generate average values $AVR|D[x]|$ of the absolute values of the component data. The average may be the arithmetic mean, or may be calculated in any one of a number of mathematically acceptable ways of calculating a value that can be defined as the average.

The apparatus may further comprise a maximum value extractor arranged to extract a plurality of maximum values of the absolute values to generate maximum absolute values of the component data and the maximum average value.

The fault diagnosing unit may be arranged to compare the ratio of each of the maximum absolute values to the maximum average value with a predetermined threshold value to determine the presence of a fault, wherein the fault is determined to be present if the ratio exceeds the predetermined value.

The fault diagnosing unit may be arranged to determine the seriousness of the fault based on the amount by which the ratio exceeds the predetermined value.

The apparatus may further comprise a reference value storage unit for storing a reference value REF.

The fault diagnosing unit may be arranged to compare each of the absolute values of the component data with the stored reference value to determine the presence of a fault, wherein the fault is determined to be present if any of the absolute values exceeds the reference value.

The fault diagnosing unit may be arranged to determine the seriousness of the fault based on the amount by which the absolute value exceeds the reference value.

The reference value may comprise an initial reference value that is provided to the fault diagnosing unit on initial operation of the apparatus.

The apparatus may be arranged to multiply the average value by a predetermined coefficient k to generate a scaled average value $kAVR|D[x]|$, compare the scaled average value $(kAVR|D[x]|)$ to the reference value REF and update the reference value with the scaled average value if the scaled average value is greater than the reference value.

The fault diagnosing unit may be arranged to identify the component data in which the fault occurred based on the presence of the fault, for example the level of the component data at which the fault occurred.

The component data may comprise high frequency component data.

An energy storage system may comprise a power conversion system for selectively connecting a grid system, a generation system and a battery system, further comprising the apparatus as defined above for detecting a fault in the battery system.

According to the invention, there is further provided a method for detecting a fault in a battery system, comprising receiving a voltage signal v(t) from a battery system, digitizing the voltage signal to generate voltage data V[x], performing discrete wavelet transformation on the voltage data to generate component data $D_j[x]$ and detecting a fault in the battery system based on the component data.

Embodiments of the invention will now be described by way of example with reference to the accompanying drawings in which:

FIG. 1 is a block diagram illustrating an apparatus for detecting faults in a battery system, according to an exemplary embodiment of the present invention;

FIG. 2 is a block diagram illustrating an apparatus for detecting faults in a battery system, according to another exemplary embodiment of the present invention.

FIG. 3 is a graph illustrating a scale function and a wavelet function, according to an exemplary embodiment of the present invention;

FIG. 4 is a block diagram illustrating discrete wavelet transformation from the viewpoint of filtering;

FIG. 5 is a view illustrating coefficients of a low pass filter (LPF) and a high pass filter (HPF), according to an exemplary embodiment of the present invention;

FIG. 6 is a view illustrating a process of decomposing voltage data through multi-resolution analysis of discrete wavelet transformation;

FIG. 7 is a view illustrating down-sampling;

FIG. 8 is a view illustrating frequency bands of approximate voltage data having an $n^{th}$ level and detailed voltage data having first through $n^{th}$ levels;

FIG. 9A is a graph illustrating voltage data provided to explain a method of detecting faults, according to an exemplary embodiment of the present invention;

FIGS. 9B through 9G are graphs illustrating low frequency component data of a fifth level and high frequency component data D1 through D5 of first through fifth levels extracted from the voltage data of FIG. 9A through multi-resolution analysis of discrete wavelet transformation;

FIGS. 10A through 10C are graphs illustrating an operation of a statistical processor; and

FIG. 11 is a table illustrating operations of a maximum value extractor and a fault diagnosing unit.

Certain advantages and features and certain aspects of methods of achieving the advantages and features are described with reference to the accompanying drawings, in which exemplary embodiments are shown. The invention may, however, be embodied in many different forms and should not be construed as being limited to the embodiments set forth herein.

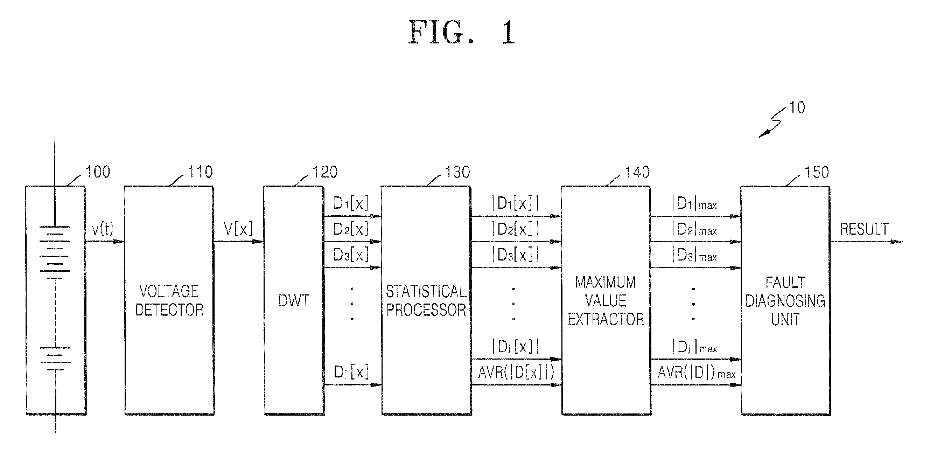

Referring to FIG. 1, the fault detecting apparatus 10 is connected to a battery system 100 and includes a voltage detector 110, a discrete wavelet transformer (DWT) 120, a statistical processor 130, a maximum value extractor 140, and a fault diagnosing unit 150.

The battery system 100 includes a battery which is supplied with electric energy from an external source to store the electric energy and supplies the stored electric energy to externally connected electric loads.

The battery system 100 includes the battery, a protection circuit which protects the battery, and a battery management system which controls the protection circuit to protect the battery. For example, if an over-current or an over-discharge situation occurs, the battery management system opens a switch of the protection circuit to separate the battery from an input/output (I/O) terminal. The battery management system monitors a state of the battery, i.e., a temperature, a voltage, a current, etc. of the battery, to collect various types of data such as voltage data, current data, and temperature data. The battery management system performs cell balancing operations of battery cells according to the collected data and an internal algorithm. The apparatus 10 for detecting the faults in the battery system 100 may be included in the battery management system.

The battery system 100 may be a part of an energy storage system which is connected to a generation system and a grid system to stably supply power to a load. The energy storage system may store electric energy generated by the generation system in the battery or supply the electric energy to the grid system, and may supply the electric energy stored in the battery to the grid system or store the electric energy supplied from the grid system in the battery. The energy storage system supplies the electric energy generated by the generation system or the electric energy stored in the battery to the load. For this purpose, the energy storage system includes a power conversion system (PCS), the battery system 100, a first switch, and a second switch.

The PCS includes power conversion apparatuses, such as an inverter, a converter, a rectifier, etc., and an integrated controller to convert electric energy provided from the generation system, the grid system, and the battery system 100 into appropriate electric energy and supply it to a place requiring the electric energy. The integrated controller monitors states of the generation system, the grid system, the battery, and the load and controls the first switch, the second switch, the battery system 100, and the power conversion apparatuses according to an algorithm or a command of an operator. The fault detecting apparatus 10 may be included in the integrated controller of the energy storage system.

The voltage detector 110 receives a voltage v(t) from the battery system 100 and digitizes the voltage v(t) to generate and store voltage data V[x]. A sampling rate of the voltage detector 110 may be between 1 to 10 times per second. However, the present invention is not limited thereto, and the sampling rate may be smaller than 1 or greater than 10 times per second.

The voltage v(t) may be a terminal voltage of an output terminal of the battery system 100. According to another example, the voltage v(t) may be a cell voltage of a particular battery cell of the battery system 100. The voltage v(t) has an analog value that changes according to a current profile input into or output from the battery system 100.

The voltage data V[x] has a digital value generated by digitizing the voltage v(t) varied according to a time t.

The voltage data V[x] includes a set of digital values defined according to a time x. The voltage detector 110 stores the voltage data V[x] during a period for determining whether the faults occur. Therefore, the voltage detector 110 may include an analog-to-digital converter (ADC) which converts the analog voltage v(t) into digital voltage data V[x]. The voltage detector 110 may further include a memory which stores the generated digital voltage data V[x].

The DWT 120 performs discrete wavelet transformation with respect to the voltage data V[x] provided from the voltage detector 110 to generate high frequency component data $D_1[x]$, $D_2[x]$, $D_3[x]$, ..., and $D_j[x]$. In the present exemplary embodiment, the high frequency component data $D_1[x]$, $D_2[x]$, $D_3[x]$, ..., and $D_j[x]$ of first through $j^{th}$ levels are generated. Here, j is a natural number greater than 2.

The high frequency component data $D_1[x]$ of the first level may be data having the highest frequency band. The high frequency component $D_2[x]$ of the second level may be data having a lower frequency band than a frequency band of the high frequency component data $D_1[x]$ of the first level. The high frequency component data $D_j[x]$ of the $j^{th}$ level may be data having the lowest frequency band.

For example, if the high frequency component data $D_1[x]$ of the first level is data having a higher frequency band than a particular frequency $f_o$, the high frequency component $D_2[x]$ of the second level may be data having a higher frequency band than a frequency $f_o/2$, the high frequency component data $D_3[x]$ of the third level may be data having a frequency band lower than the frequency $f_o/2$ and higher than a frequency $f_o/4$, and the high frequency component data ($D_j[x]$ of the $j^{th}$ level may be data having a frequency lower than a frequency $f_o/2^{j-1}$ and higher than a frequency $f_o/2^j$.

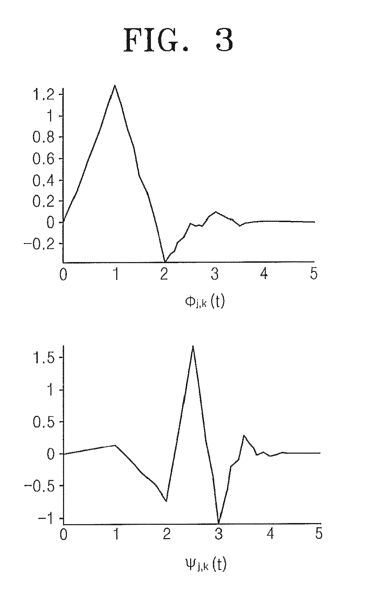

The discrete wavelet transformation will be described in detail later with reference to FIGS. 3 through 8.

The statistical processor 130 receives the high frequency component data $D_1[x]$, $D_2[x]$, $D_3[x]$, ..., and $D_j[x]$ of the first through $j^{th}$ levels generated by the DWT 120 to generate sizes, ie. the absolute values, $|D_1[x]|$, $|D_2[x]|$, $|D_3[x]|$, ..., and $|D_j[x]|$ of the high frequency component data $D_1[x]$, $D_2[x]$, $D_3[x]$, ..., and $D_j[x]$ of the first through $j^{th}$ levels and an average AVR($|D[x]|$) of the sizes $|D_1[x]|$, $|D_2[x]|$, $|D_3[x]|$, ..., and $|D_j[x]|$. The average may be the arithmetic average, or mean, calculated by summing the values and dividing by the number of values, or it may be any other type of mathematically acceptable method of calculating an average.

The statistical processor 130 removes negative and positive signs of the high frequency component data $D_1[x]$, $D_2[x]$, $D_3[x]$, ..., and $D_j[x]$ of the first through $j^{th}$ levels to generate the sizes $|D_1[x]|$, $|D_2[x]|$, $|D_3[x]|$, ..., and $|D_j[x]|$ of the high frequency component data $D_1[x]$, $D_2[x]$, $D_3[x]$, ..., and $D_j[x]$ of the first through $j^{th}$ level. The statistical processor 130 generates the average AVR($|D[x]|$) of the sizes $|D_1[x]|$, $|D_2[x]|$, $|D_3[x]|$, ..., and $|D_j[x]|$ of the high frequency component data $D_1[x]$, $D_2[x]$, $D_3[x]$, ..., and $D_j[x]$ of the first through $j^{th}$ level. The average AVR($|D[x]|$) refers to an average of sizes of the high frequency component data $D_1[x]$, $D_2[x]$, $D_3[x]$, ..., and $D_j[x]$ of the first through $j^{th}$ level at the time x.

The maximum value extractor 140 receives the sizes $|D_1[x]|$, $|D_2[x]|$, $|D_3[x]|$, ..., and $|D_j[x]|$ of the high frequency component data $D_1[x]$, $D_2[x]$, $D_3[x]$, ..., and $D_j[x]$ of the first through $j^{th}$ level and the average AVR($|D[x]|$) generated by the statistical processor 130 and extracts maximum values of the sizes $|D_1[x]|$, $|D_2[x]|$, $|D_3[x]|$, ..., and $|D_j[x]|$ and the average AVR($|D[x]|$) to generate first, second, third, ..., and $j^{th}$ maximum values $|D_1|_{max}$, $|D_2|_{max}$, $|D_3|_{max}$, ..., $|D_j|_{max}$ and a maximum average value AVR($|D|$)$_{max}$.

The first maximum value $|D_1|_{max}$ is the greatest value of the size $|D_1[x]|$ of the high frequency component data of the first level. For example, if the size $|D_1[x]|$ of the high frequency component data of the first level is greatest when $x=x_1$, the first maximum value $|D_1|_{max}$ may be equal to $|D_1[x_1]|$.

The $j^{th}$ maximum value $|D_j|_{max}$ is the greatest value of the size $|D_j[x]|$ of the high frequency component data of the $j^{th}$ level. For example, if the size $|D_j[x]|$ of the high frequency component data of the $j^{th}$ level is greatest when $x=x_j$, the $j^{th}$ maximum value $|D_j|_{max}$ may be equal to $|D_j[x_j]|$. Here, $x_1$ and $x_j$ may be the same time or different times.

The maximum average value AVR($|D|$)$_{max}$ is the greatest value of the average AVR($|D[x]|$). The time x for which the average AVR($|D[x]|$) has the greatest value may be equal to one of times (e.g., $x_1$, $x_2$, $x_3$, ..., and $x_j$) when the first through $j^{th}$ maximum values ($|D_1|_{max}$, $|D_2|_{max}$, $|D_3|_{max}$, ..., and $|D_j|_{max}$ are generated or may be different from these times.

The fault diagnosing unit 150 receives the first through $j^{th}$ maximum values $|D_1|_{max}$, $|D_2|_{max}$, $|D_3|_{max}$, ..., and $|D_j|_{max}$ and the maximum average value AVR($|D|$)$_{max}$ generated by the maximum value extractor 140 and compares the first through $j^{th}$ maximum values $|D_1|_{max}$, $|D_2|_{max}$, $|D_3|_{max}$, ..., and $|D_j|_{max}$ with the maximum average value AVR($|D|$)$_{max}$ to diagnose that the faults occur if a ratio exceeds a predetermined threshold value.

In detail, the fault diagnosing unit 150 compares a ratio of the first maximum value $|D_1|_{max}$ to the maximum average value AVR($|D|$)$_{max}$ with the predetermined threshold value to diagnose that the faults occur if the ratio is greater than the predetermined threshold value. Here, the apparatus 10 detects a fault from the high frequency component data $D_1[x]$ of the first level. In other words, the apparatus 10 detects a component of a frequency band corresponding to the high frequency component data $D_1[x]$ of the first level as a fault.

The fault diagnosing unit 150 compares a ratio of the second maximum value $|D_2|_{max}$ to the maximum average value AVR($|D|$)$_{max}$ with the predetermined threshold value to diagnose whether a fault occurs. Also, the fault diagnosing unit 150 compares a ratio of the $j^{th}$ maximum value $|D_j|_{max}$ to the maximum average value AVR($|D|$)$_{max}$ with the predetermined threshold value to diagnose whether a fault occurs. The fault diagnosing unit 150 outputs fault detection diagnosis results as a signal RESULT. The predetermined threshold value may vary according to a connection relation between the battery system 100 and batteries. For example, the predetermined threshold value may be one value between 2 and 5. For example, the predetermined threshold value may be 2.5, determined for example through a trial and error determination to find a level below which faults are not present.

If the ratios of the first through $j^{th}$ maximum values $|D_1|_{max}$, $|D_2|_{max}$, $|D_3|_{max}$, ..., and $|D_j|_{max}$ to the maximum average value $AVR(|D|)_{max}$ are lower than the predetermined threshold value, the fault diagnosing unit 150 outputs a signal RESULT indicating that the faults do not occur. If any one of the ratios of the first through $j^{th}$ maximum values $|D_1|_{max}$, $|D_2|_{max}$, $|D_3|_{max}$, ..., and $|D_j|_{max}$ to the maximum average value $AVR(|D|)_{max}$ is higher than the predetermined threshold value, the fault diagnosing unit 150 outputs a signal RESULT indicating that the faults occur.

The apparatus 10 according to the present invention diagnoses whether the faults occur, through the voltage v(t) output from the battery system 100. For example, if a high current flows into the battery system 100, the voltage v(t) output from the battery system 100 rapidly increases. The apparatus 10 decomposes the voltage v(t) into several frequency band components through multi-resolution analysis of the discrete wavelet transformation to accurately diagnose whether the faults occur.

The apparatus 10 may obtain information as to high frequency component data from which a fault is detected and thus checks a cause of the fault. The apparatus 10 detects the ratios of the first through $j^{th}$ maximum values $|D_1|_{max}$, $|D_2|_{max}$, $|D_3|_{max}$, ..., and $|D_j|_{max}$ to the maximum average value $AVR(|D|)_{max}$ and thus determines a degree of seriousness of the fault.

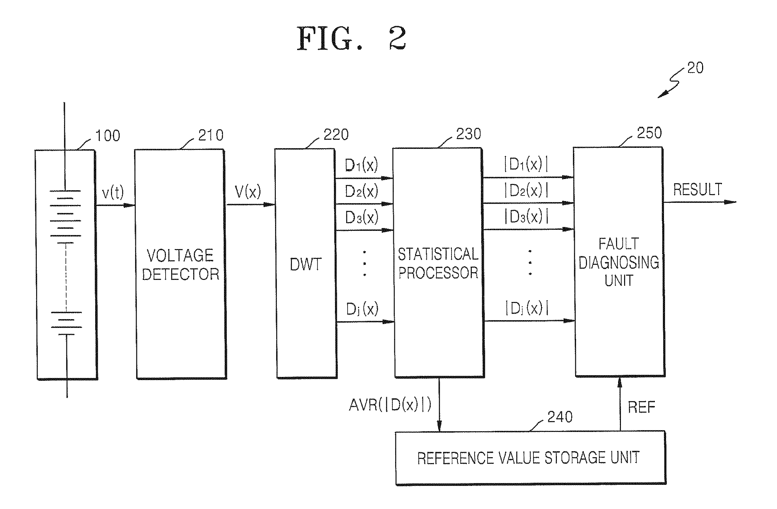

FIG. 2 is a block diagram illustrating a fault detecting apparatus 20 for detecting faults in a battery system, according to an exemplary embodiment of the present invention. Referring to FIG. 2, the apparatus 20 is connected to a battery system 100 and includes a voltage detector 210, a DWT 220, a statistical processor 230, a reference value storage unit 240, and a fault detector 250.

The battery system 100 of FIG. 2 is equal to the battery system 100 of FIG. 1. The battery system 100 includes a battery which is supplied with electric energy from an external source, stores the electric energy, and supplies the stored electric energy to externally connected electric loads.

The voltage detector 210 receives a voltage v(t) from the battery system 100 and digitizes the voltage v(t) in real time to output voltage data V(x) according to a time x. A sampling rate of the voltage detector 210 may be 1 to 10 times per second. However, the present invention is not limited thereto, and thus the sampling rate may be smaller than 1 or greater than 10 times per second.

The voltage v(t) may be a terminal voltage of the battery system 100 or a cell voltage of a particular battery cell of the battery system 100. The voltage data V(x) is a digital value generated by digitizing the voltage v(t) according to a time t, and x denotes a time. The voltage detector 210 includes an ADC which converts the analog voltage v(t) into the digital voltage data V(x) in real time.

The DWT 220 performs discrete wavelet transformation with respect to the voltage data V(x) generated by the voltage detector 110 to generate high frequency component data $D_1(x)$, $D_2(x)$, $D_3(x)$, ..., and $D_j(x)$ having a plurality of levels.

The high frequency component data $D_1(x)$ of the first level may be data having the highest frequency band. The high frequency component data $D_2(x)$ of the second level may be data having a frequency band lower than the frequency band of the high frequency component data $D_1(x)$ of the first level. The high frequency component data $D_j(x)$ of the $j^{th}$ level may be data having the lowest frequency band.

The statistical processor 230 receives the high frequency component data $D_1(x)$, $D_2(x)$, $D_3(x)$, ..., and $D_j(x)$ of the first through $j^{th}$ levels generated by the DWT 220 to generate sizes $|D_1(x)|$, $|D_2(x)|$, $|D_3(x)|$, ..., and $|D_j(x)|$ of the high frequency component data $D_1(x)$, $D_2(x)$, $D_3(x)$, ..., and $D_j(x)$ of the first through $j^{th}$ levels. The statistical processor 230 generates an average $AVR(|D(x)|)$ of the sizes $|D_1(x)|$, $|D_2(x)|$, $|D_3(x)|$, ..., and $|D_j(x)|$ of the high frequency component data $D_1(x)$, $D_2(x)$, $D_3(x)$, ..., and $D_j(x)$ of the first through $j^{th}$ levels and provides the average $AVR(|D(x)|)$ to the reference voltage storage unit 240.

The reference value storage unit 240 stores a reference value REF and provides the reference value to the fault detector 250.

The fault detector 250 receives the sizes $|D_1(x)|$, $|D_2(x)|$, $|D_3(x)|$, ..., and $|D_j(x)$ of the high frequency component data $D_1(x)$, $D_2(x)$, $D_3(x)$, ..., and $D_j(x)$ of the first through $j^{th}$ levels from the statistical processor 230 and compares the sizes $|D_1(x)|$, $|D_2(x)|$, $|D_3(x)|$, ..., and $|D_j(x)|$ of the high frequency component data $D_1(x)$, $D_2(x)$, $D_3(x)$, ..., and $D_j(x)$ of the first through $j^{th}$ levels with the reference value REF received from the fault detector 250 to detect whether faults occur, in real time.

In detail, the fault detector 250 compares the sizes $|D_1(x)|$, $|D_2(x)|$, $|D_3(x)|$, , ..., and $|D_j(x)|$ of the high frequency component data $D_1(x)$, $D_2(x)$, $D_3(x)$, ..., and $D_j(x)$ of the first through $j^{th}$ levels with the reference value REF and detects that the faults occur if any one of the sizes $|D_1(x)|$, $|D_2(x)|$, $|D_3(x)|$, ..., and $|D_j(x)|$ of the high frequency component data $D_1(x)$, $D_2(x)$, $D_3(x)$, ..., and $D_j(x)$ of the first through $j^{th}$ levels is greater than the reference value REF. The fault detector 250 outputs a signal RESULT indicating that the faults occur.

If the sizes $|D_1(x)|$, $|D_2(x)|$, $|D_3(x)|$, ..., and $|D_j(x)|$ of the high frequency component data $D_1(x)$, $D_2(x)$, $D_3(x)$, ...,

and D_j(x) of the first through j$^{th}$ levels are all smaller than the reference value REF, the fault detector 250 outputs a signal RESULT indicating that the faults do not occur.

The sizes $|D_1(x)|$, $|D_2(x)|$, $|D_3(x)|$, ..., and $|D_j(x)|$ of the high frequency component data $D_1(x)$, $D_2(x)$, $D_3(x)$, ..., and $D_j(x)$ of the first through j$^{th}$ levels are values which are generated in real time from the voltage v(t) of the battery system 100 through the DWT 210 and the statistical processor 230. The fault detector 250 receives the sizes $|D_1(x)|$, $|D_2(x)|$,$|D_3(x)|$, ..., and $|D_j(x)|$ of the high frequency component data $D_1(x)$, $D_2(x)$, $D_3(x)$, ..., and $D_j(x)$ of the first through j$^{th}$ levels in real time and compares sizes $|D_1(x)|$, $|D_2(x)|$,$|D_3(x)|$, ..., and $|D_j(x)|$ of the high frequency component data $D_1(x)$, $D_2(x)$, $D_3(x)$, ..., and $D_j(x)$ of the first through j$^{th}$ levels with the reference value REF to immediately sense whether the faults occur.

The reference value storage unit 240 stores an initial reference value REF$_{ini}$. The reference value storage unit 240 outputs the initial reference value REF$_{ini}$ as the reference value REF when the apparatus 20 initially operates. The initial reference value REF$_{ini}$ may vary according to the battery system 100. For example, the initial reference value REF$_{ini}$ may be a value between 2 and 5. For example, the initial reference value REF$_{ini}$ may be 2.5.

The reference value storage unit 240 receives the average AVR($|D(x)|$) from the statistic processor 230. The reference value storage unit 240 multiplies the average AVR($|D(x)|$) by a predetermined coefficient k to calculate a value kAVR($|D(x)|$). According to another example, the statistical processor 230 may provide the value kAVR($|D(x)|$) calculated by multiplying the average AVR($|D(x)|$) by the predetermined coefficient k to the reference value storage unit 240.

The predetermined coefficient k may vary according to the battery system 100. For example, the coefficient k may be a value between 2 and 5. For example, the coefficient k may be 2.5.

The reference value storage unit 240 compares the value kAVR($|D(x)|$) with the reference value REF and, if the value kAVR($|D(x)|$) is greater than the reference value REF, updates the reference value REF as the value kAVR($|D(x)|$). Since the reference value REF has the initial reference value REF$_{ini}$ when the apparatus 20 initially operates, the reference value storage unit 240 compares the value (kAVR($|D(x)|$) with the initial reference value REF$_{ini}$ and, if the value kAVR($|D(x)|$) becomes greater than the initial reference value REF$_{ini}$, updates the reference value REF as the value KAVR($|D(x)|$). This updating process is performed in real time, and the reference value storage unit 240 stores the greater one of the initial reference value REF$_{ini}$ and a value KAVR$(|D|)_{max}$ calculated by multiplying a maximum value of the average AVR($|D(x)|$) by the coefficient k as the reference value REF.

For example, if the initial reference value REF$_{ini}$ and the coefficient k are each 2.5, and the average AVR($|D(x)|$) is smaller than 1, the reference value REF is 2.5. If the average AVR($|D(x)|$) is greater than 2.5, i.e., is 2.7, when x=x$_1$, the reference value REF is updated as 2.7. If the average AVR($|D(x)|$) is greater than 2.7 when x=x$_2$, e.g., is 3.1, the reference value REF is updated as 3.1.

The apparatus 20 collects the voltage v(t) output from the battery system 100 to detect whether the faults occur, in real time. For example, if a high current flows into the battery system 100, the voltage v(t) output from the battery system 100 rapidly increases. Also, the apparatus 20 decomposes the voltage v(t) into components of several frequency bands through multi-resolution analysis of the discrete wavelet transformation to detect that a peak greater than the reference value REF occurs in the component of the particular frequency band in order to sense that the faults occur, in real time.

In addition, the apparatus 20 may obtain information as to high frequency component data from which a fault is detected and thus checks a cause of the fault. Also, the apparatus 20 obtains information about a degree of seriousness of the fault through a peak value of the component of the particular frequency band.

The discrete wavelet transformation will now be described. A wavelet transform is used to convert a size and a horizontal position of a circular wavelet function to decompose a source signal x(t). A continuous wavelet transform (CWT) is defined as in Equation 1 below:

$$W^{\int}(a,b) = < x(t), \Psi_{a,b}(t) > = \frac{1}{\sqrt{a}} \int_{-\infty}^{\infty} x(t) \Psi * \left( \frac{t-b}{a} \right) dt \qquad ...(1)$$

wherein a and b denote parameters respectively indicating a scale and a translation, $\psi$(t) denotes a wavelet analytic function, and $\psi$* denotes a complex conjugate function. The result of Equation 1 is a wavelet coefficient of the scale and translation parameters. If a=2$^j$ and b = k2$^j$ are substituted for Equation 1, a discrete wavelet transform is defined as in Equation 2. Integers j and k are respectively scale and translation variables.

$$W^{|}(j,k) = <x(t), \Psi_{j,k}(t)> = \frac{1}{\sqrt{2^{j}}} \int_{-\infty}^{\infty} x(t) \Psi * \left( \frac{t-k2^{j}}{2^{j}} \right) dt \qquad ...(2)$$

A scale function $\varphi$ and a wavelet function $\psi$ are used in one-dimensional signal decomposition. The wavelet function $\psi$ is used to obtain a detailed component $D_j$ from the source signal x(t), and the scale function $\Phi$ is used to decompose an approximate component $A_j$ from the source signal x(t). FIG 3 is a graph illustrating the scale function $\varphi$ and the wavelet function $\psi$ according to an exemplary embodiment of the present invention. The scale function $\varphi$ and the wavelet function $\psi$ shown in FIG. 3 are based on a Daubechies 3 (dB3) wavelet.

Approximate information $x_a^j(t)$ and detailed information $x_d^j(t)$ obtained in an arbitrary scale j from the source signal x(t) in the DWT may be respectively represented as in Equation 3 below:

$$x_a^j(t) = \sum_k a_{j,k} \phi_k(2^{-j}t) = \sum_k a_{j,k} \phi_{j,k}(t), k \in Z$$
$$x_d^j(t) = \sum_k d_{j,k} \psi_k(2^{-j}t) = \sum_k d_{j,k} \psi_{j,k}(t), k \in Z \qquad ...(3)$$

wherein $a_{j,k}$ and $d_{j,k}$ respectively denote an approximate coefficient (a scale coefficient) and a detailed coefficient (a wavelet coefficient).

The source signal x(t) may be expressed as in Equation 4 by using the approximate information $x_a^j(t)$ and the detailed information $x_d^j(t)$.

$$x(t) = \sum_k a_{j,k} 2^{-\frac{j}{2}} \phi(2^{-j}t - k) + \sum_{j=1} \sum_k d_{j,k} 2^{-\frac{j}{2}} \psi(2^{-j}t - k) \qquad ...(4)$$

$a_{j,k}$ and $d_{j,k}$ may be expressed as in Equation 5 by using the scale function $\varphi$ and the wavelet function $\psi$.

$$a_{j,k} = <x(t), \phi_{j,k}(t)> = \int_r x(t) 2^{-\frac{j}{2}} \phi * (2^{-j}t - k) dt$$
$$d_{j,k} = <x(t), \psi_{j,k}(t)> = \int_R x(t) 2^{-\frac{j}{2}} \psi * (2^{-j}t - k) dt \qquad ...(5)$$

The approximate information $x_a^j(t)$ corresponds to a scale function $\varphi_{j,k}(t)$ that is a low frequency component, and the detailed information $x_d^j(t)$ corresponds to a wavelet function $\psi_{j,k}(t)$ that is a high frequency component. If the approximate information $x_a^j(t)$ is A, and the detailed information $x_d^j(t)$ is D, a signal x(t) may be multi-resolution-decomposed into nth levels and expressed as in Equation 6:

$$x(t) = A_n + D_1 + D_2 + ... + D_{n-1} + D_n \qquad ...(6)$$

If detailed information $D_n$ is added to approximate information An, approximate information having a one level higher resolution is obtained. In other words, $A_{n-1}$ = An + $D_n$. Also, x(t) may be expressed with $A_1$ + $D_1$.

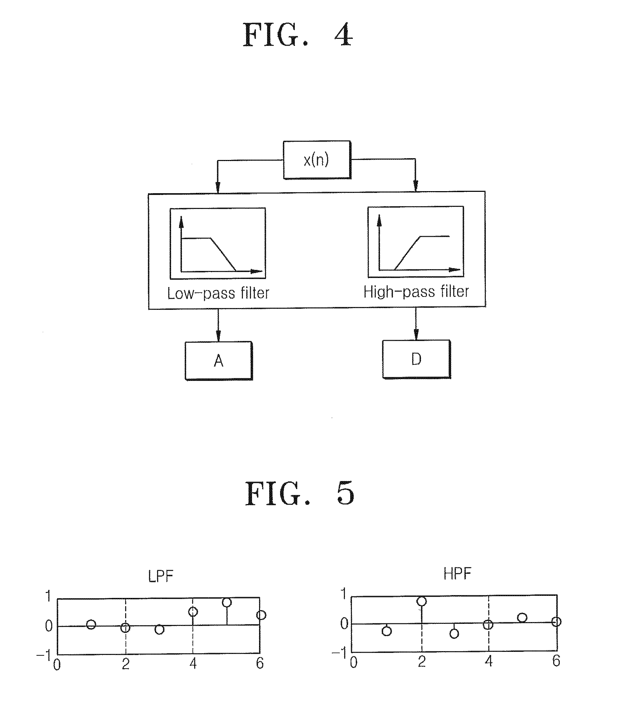

FIG. 4 is a block diagram illustrating discrete wavelet transformation from the viewpoint of filtering.

Data x(n) in a discrete wavelet transform may be decomposed into approximate information A corresponding to a low frequency component and detailed information D corresponding to a high frequency component. A low pass filter (LPF) may be used to extract the approximate information A from the data x(n). A high pass filter (HPF) may be used to extract the detailed information D from the data x(n). The LPF and the HPF are not real filters which are realized physically or as circuits but may be realized by data-processing.

FIG. 5 is view illustrating coefficients of a LPF and a HPF, according to an exemplary embodiment of the present invention.

For example, as shown in FIG. 5, the coefficients of the LPF may be 0.0352, -0.0854, - 0.1350, 0.4599, 0.8069, and 0.3327, and the coefficients of the HPF may be -0-3327, 0.8069, -0.4599, -0.1350, 0.0854, and 0.0352

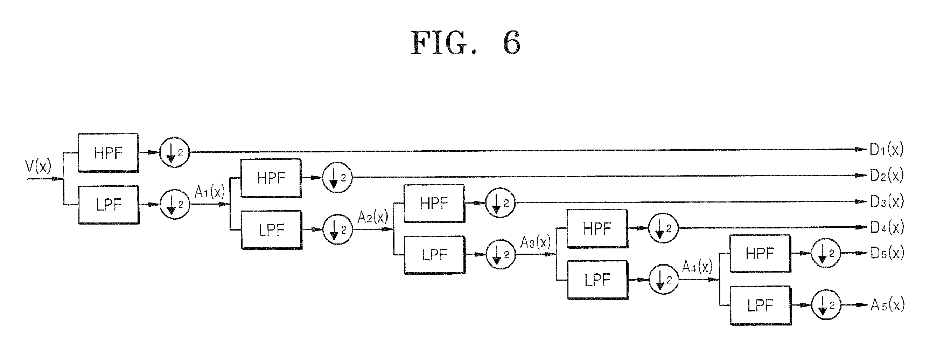

FIG. 6 is view illustrating a process of decomposing voltage data V(x) through multi-resolution analysis of discrete wavelet transformation. The discrete wavelet transformation is repeatedly performed five times in FIG. 6, but the number of repetitions of the discrete wavelet transformation is not limited thereto. The discrete wavelet transformation may be performed one time or may be performed five or more times.

The voltage data V(x) is decomposed into approximate voltage data $A_1(x)$ of a first level and detailed voltage data $D_1(x)$ of a first level by using a first discrete wavelet transform and down-sampling. The approximate voltage data $A_1(x)$ of the first level is decomposed into approximate voltage data $A_2(x)$ of a second level and detailed voltage data $D_2(x)$ of a second level by using a second discrete wavelet transform and down-sampling.

The approximate voltage data $A_2(x)$ of the second level is decomposed into approximate voltage data $A_3(x)$ of a third level and detailed voltage data $D_3(x)$ of a third level by using a third discrete wavelet transform and down-sampling. The approximate voltage data $A_3(x)$ of the third level is decomposed into approximate voltage data $A_4(x)$ of a fourth level and detailed voltage data $D_4(x)$ of a fourth level by using a fourth discrete wavelet transform and down-sampling. The approximate voltage data $A_4(x)$ of the fourth level is decomposed into approximate voltage data $A_5(x)$ of a fifth level and detailed voltage data $D_5(x)$ of a fifth level by using a fifth discrete wavelet transform and down-sampling.

The detailed voltage data $D_1(x)$, $D_2(x)$, $D_3(x)$, $D_4(x)$, and $D_5(x)$ of the first through fifth levels may be provided as high frequency component data $D_1(x)$, $D_2(x)$, $D_3(x)$, $D_4(x)$, and $D_5(x)$ of first through fifth levels to the statistical processor 130 or 230.

As shown in FIG. 6, the voltage data V(x) is expressed by using the approximate voltage data $A_5(x)$ of the fifth level and the detailed voltage data $D_1(x)$, $D_2(x)$, $D_3(x)$, $D_4(x)$, and $D_5(x)$ of the first through fifth levels. Also, approximate voltage data $A_{n-1}(x)$ of an $n-1^{th}$ level is expressed as a sum of approximate voltage data of an $n^{th}$ level $A_n(x)$ and detailed voltage data $D_n(x)$ of an $n^{th}$ level.

In the present example, the voltage data V(x) is recovered from the approximate voltage data $A_5(x)$ of the fifth level and the detailed voltage data $D_1(x)$, $D_2(x)$, $D_3(x)$, $D_4(x)$, and $D_5(x)$ of the first through fifth levels. This recovering process may be referred to as inverse discrete wavelet transformation (IDWT).

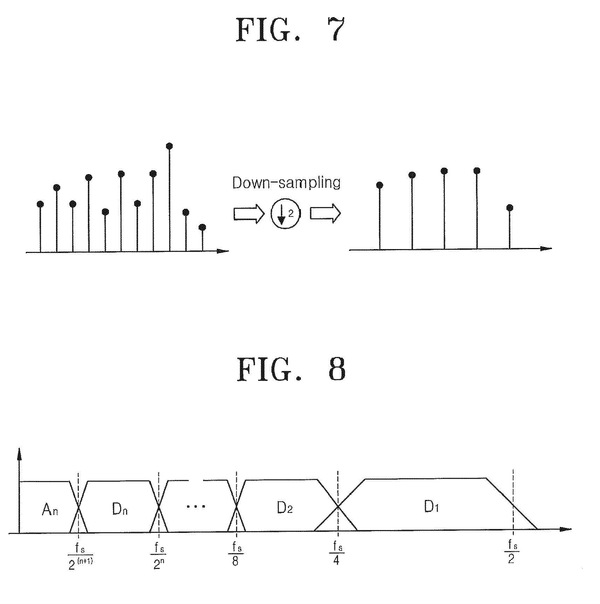

As shown in FIG. 6, if discrete wavelet transformation is repeated, a whole amount of data increases. This is because the voltage data V(x) is decomposed into approximate voltage data A(x) and detailed voltage data D(x). Therefore, after the discrete wavelet transformation is performed, down-sampling may be performed. The down-sampling is performed to select an even number or an odd number of approximate voltage data generated by a previous discrete wavelet transform and to remove unselected data. FIG. 7 is a view illustrating down-sampling. As shown in FIG. 7, n data is reduced to n/2 data through down-sampling.

FIG. 8 is a view illustrating a frequency band of approximate voltage data $A_n(x)$ of an $n^{th}$ level and frequency bands of detailed voltage data $D_1(x)$, $D_2(x)$, ..., and $D_n(x)$ of first through $n^{th}$ levels.

If the detailed voltage data $D_1(x)$ of the first level is data having a frequency band smaller than a first frequency $f_s/2$ and greater than a second frequency $f_s/4$, the detailed voltage data $D_2(x)$ of the second level corresponds to data having a frequency band smaller than the second frequency $f_s/4$ and greater than a third frequency $f_s/8$. The detailed voltage data $D_3(x)$ of the third level corresponds to data having a frequency band smaller than the third frequency $f_s/8$ and greater than a fourth frequency $f_s/16$. Also, the detailed voltage data $D_n(x)$ of the $n^{th}$ level corresponds to data having a frequency band smaller than an $n^{th}$ frequency $f_s/2^n$ and greater than a $n+1^{th}$ frequency $f_s/2^{n+1}$. The approximate voltage data $A_n(x))$ of the $n^{th}$ level corresponds to data having a frequency band smaller than the $n+1^{th}$ frequency $f_s/2^{n+1}$.

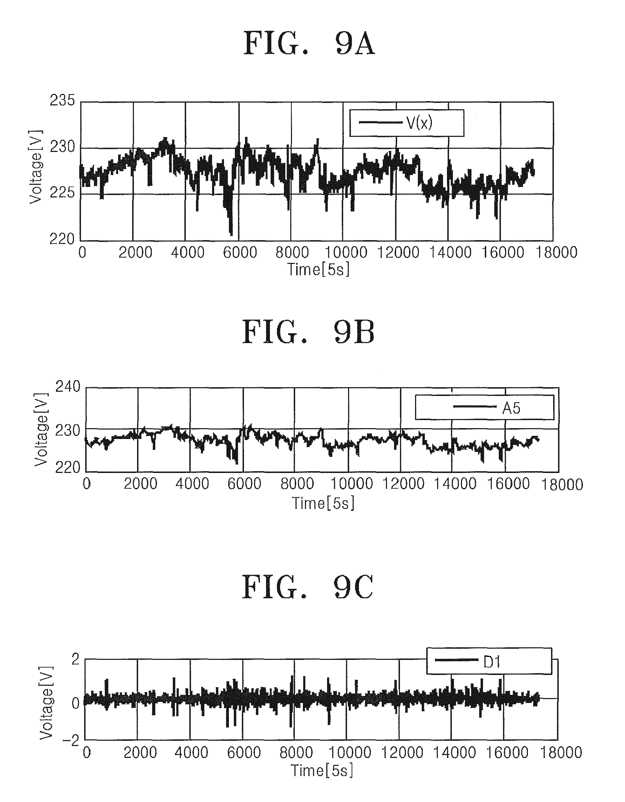

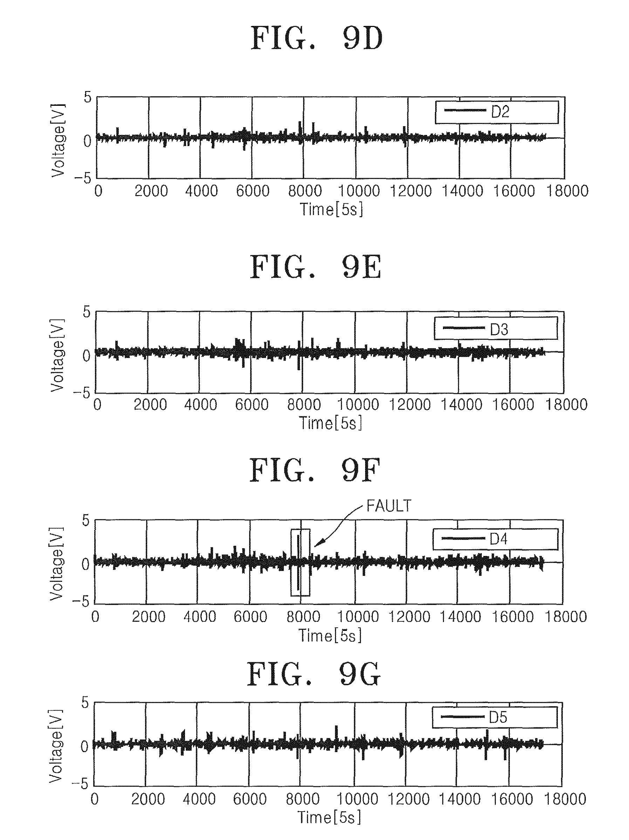

FIG. 9A is a graph illustrating voltage data V(x) provided to illustrate a method of detecting faults, according to an exemplary embodiment of the present invention. FIGS. 9B through 9G are graphs illustrating low frequency component data A5 of a fifth level and high frequency component data D1 through D5 of first through fifth levels extracted from the voltage data V(x) of FIG. 9A through multi-resolution analysis of discrete wavelet transformation.

Referring to FIG. 9A, the voltage data V(x) is exemplarily illustrated with respect to a time x.

Referring to FIGS. 9B through 9G, the low frequency component data A5 of the fifth level and the high frequency component data D1 through D5 of the first through fifth levels are extracted from the voltage data V(x) through the multi-resolution analysis of the discrete wavelet transformation.

The low frequency component data A5 of the fifth level is similar to the voltage data V(x), and high frequency component data is removed from the voltage data V(x). The low frequency component data A5 of the fifth level may be referred to as approximate voltage data of a fifth level.

The high frequency component data D1 through D5 of the first through fifth levels have negative and positive values based on o. If the high frequency component data D1 through D5 of the first through fifth levels are integrated with respect to a time, an integral value is o.

If a charging time and a discharging time are short, i.e., charging and discharging are frequently alternately performed, values of the high frequency component data D1 through 5D increase as shown on the graphs. However, if the charging time and the discharging time are long, variations between charging and discharging may not appear in the high frequency component data D1 through D5.

If a high current rapidly flows into a battery system due to faults, it is difficult to detect a rapid variation in the low frequency component data A5, but it is easy to detect rapid variations in the high frequency component data D1 through D5.

The high frequency component data D4 of the fourth level has a high peak at a time slightly faster than about 8000 differently from the other high frequency component data D1 through D3 and D5. The other high frequency component data D1 through D3 and D5 do not have high peaks at the same time, but the high peak is detected in the high frequency component data D4 of the fourth level, thereby diagnosing that faults occur. For example, if a size of a peak exceeds a predetermined normal range, it is diagnosed that the faults occur.

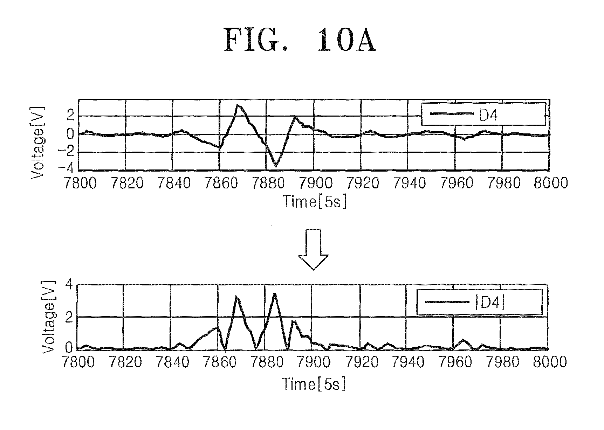

FIGS. 10A through 10C are graphs illustrating an operation of the statistical processor 130.

Referring to FIG. 10A, the statistical processor 130 generates a size |D4| of high frequency component data of a fourth level from the high frequency component data D4 of the fourth level.

The size |D4| of the high frequency component data of the fourth level is generated by covering an absolute value on the high frequency component data of the fourth level. In other words, data of high frequency component data D4 of a fourth level having a negative value is converted into data having a positive value with the same size.

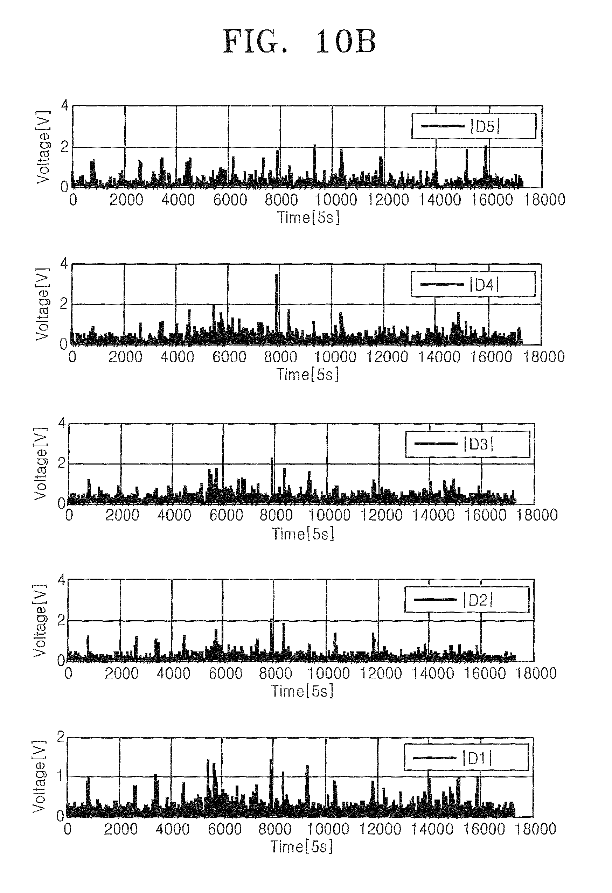

Referring to FIG. 10B, the statistical processor 130 generates sizes |D1| through |D5| of high frequency component data D1 through D5 of first through fifth levels. The graphs of FIG. 10B illustrating the sizes |D1|-|D5| of the high frequency component data D1 through D5 of the first through fifth levels are generated from the graphs of FIGS. 9C to 9G illustrating the high frequency component data D1 through D5 of the first through fifth levels.

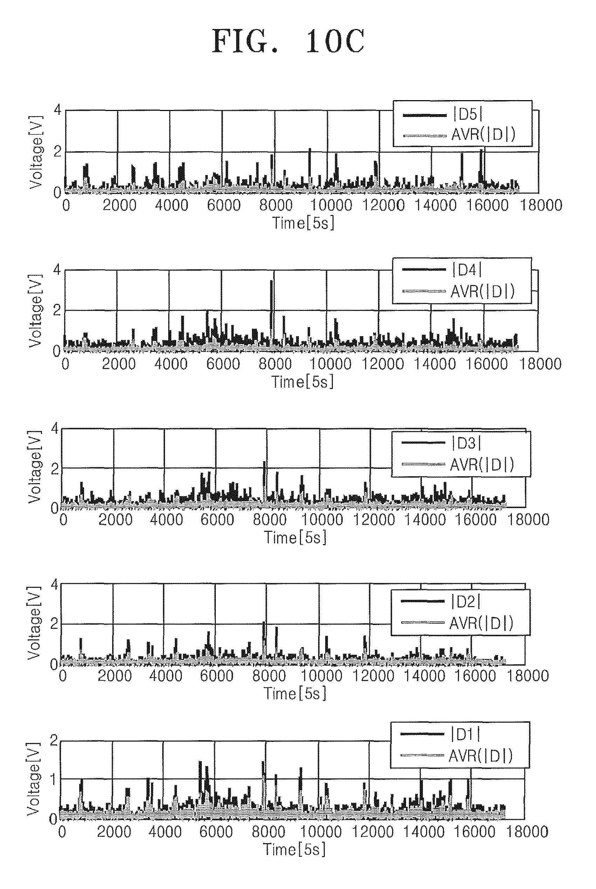

FIG. 10C illustrate an average AVR(|D|) and sizes |D1|-|D5| of high frequency component data of first through fifth levels generated by the statistical processor 130. The average AVR(|D|) is an average of the sizes |D1|-|D5| of the high frequency component data of the first through fifth levels and is generated by the statistical processor 130.

Referring to the second graph illustrating the size |D| of the high frequency component data of the fourth level and the average AVR(|D|), the size |D| of the high frequency component data of the fourth level has a much greater value than a maximum value of averages AVR(|D|) at around time x(=8000). The maximum value of the averages AVR(|D|) may be a criterion for determining a normal range indicating that the battery system 100 operates normally. In detail, the size |D| of the high frequency component data of the fourth level has a value exceeding 3 times the maximum value of the average AVR(|D|). If a threshold value is 2.5, a peak exceeding 3 times the maximum value of the averages AVR(|D|) occurs in the high frequency component data D4 of the fourth level. Therefore, an occurrence of faults is detected.

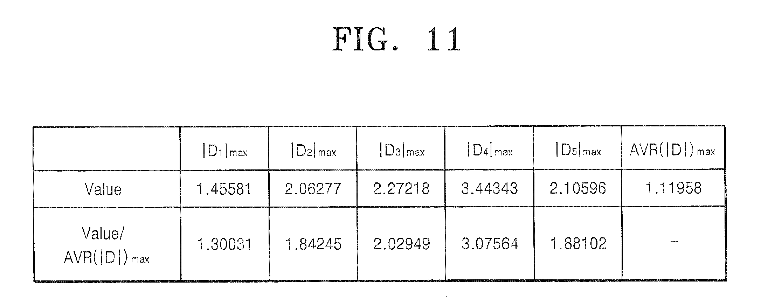

FIG. 11 is a table illustrating operations of the maximum value extractor 140 and the fault diagnosing unit 150, according to an exemplary embodiment of the present invention.

Referring to FIG. 11, the maximum value extractor 140 extracts first through fifth maximum values $|D_1|_{max}$, $|D_2|_{max}$, $|D_3|_{max}$, $|D_4|_{max}$, and $|D_5|_{max}$ from sizes [D1|-|D5] of high frequency component data of first through fifth levels. In the present exemplary embodiment, the first through fifth maximum values $|D_1|_{max}$, $|D_2|_{max}$, $|D_3|_{max}$, $|D_4|_{max}$, and $|D_5|_{max}$ may be respectively 1.45581, 2.06277, 2.27218, 3.44343, and 2.10596. The maximum value extractor 140 extracts an average maximum value AVR(|D|)$_{max}$ from an average AVR(|D|). In the present exemplary embodiment, the average maximum value AVR(|D|)$_{max}$ may be 1.11958.

The fault diagnosing unit 150 receives the first through fifth maximum values $|D_1|_{max}$, $|D_2|_{max}$, $|D_3|_{max}$, $|D_4|_{max}$, and $|D_5|_{max}$ and the average maximum value AVR(|D|)$_{max}$ from the maximum value extractor 140. The fault diagnosing unit 150 calculates ratios of the first through fifth maximum values $|D_1|_{max}$, $|D2|_{max}$, $|D_3|_{max}$, $|D_4|_{max}$, and $|D_5|_{max}$ to the average maximum value AVR(|D|)$_{max}$. According to the present exemplary embodiment, the ratios of the first through fifth maximum values $|D_1|_{max}$, $|D_2|_{max}$, $|D_3|_{max}$, $|D_4|_{max}$, and $|D_5|_{max}$ to the average maximum value AVR(|D|)$_{max}$ may be respectively 1.30031, 1.84245, 2.02949, 3.07564, and 1.88102.

Here, the fault diagnosing unit 150 determines whether the ratios are greater than a threshold value and, if any one of the ratios is greater than the threshold value, diagnoses that faults occur. Here, the threshold value may be 2.5.

Since the ratio of the fourth maximum value $|D_4|_{max}$ to the average maximum value AVR(|D|)$_{max}$ is 3.07564 which is greater than 2.5, the fault diagnosing unit 150 diagnoses that the faults occur.

It will be understood by those of ordinary skill in the art that various modifications, combinations, and changes can be made within the scope of the invention as defined by the claims.

**Claims**

1. An apparatus (10, 20) for detecting a fault in a battery system (100), the apparatus comprising:

   a voltage detector (110, 210) arranged to receive a voltage signal v(t) from a battery system (100) and to digitize the voltage signal to generate voltage data V[x];
   a discrete wavelet transformation unit (120, 220) arranged to perform discrete wavelet transformation on the voltage data to generate component data $D_j[x]$; and
   a fault diagnosing unit (150, 250) arranged to detect a fault in the battery system based on the component data.

2. The apparatus of claim 1, further comprising a statistical processor (130, 230) arranged to process the component data to generate absolute values $|D_j[x]|$ of the component data.

3. The apparatus of claim 2, wherein the statistical processor is arranged to generate average values AVR|D[x]| of the absolute values of the component data.

4. The apparatus of claim 3, further comprising a maximum value extractor (140) arranged to extract a plurality of maximum values of the absolute values to generate maximum absolute values of the component data and the maximum average value.

5. The apparatus of claim 4, wherein the fault diagnosing unit (150) is arranged to compare the ratio of each of the maximum absolute values to the maximum average value with a predetermined threshold value to determine the presence of a fault, wherein the fault is determined to be present if the ratio exceeds the predetermined value.

6. The apparatus of claim 5, wherein the fault diagnosing unit is arranged to determine the seriousness of the fault based on the amount by which the ratio exceeds the predetermined value.

7. The apparatus of claim 2 or 3, further comprising a reference value storage unit (240) for storing a reference value REF.

8. The apparatus of claim 7, wherein the fault diagnosing unit (250) is arranged to compare each of the absolute values of the component data with the stored reference value to determine the presence of a fault, wherein the fault is determined to be present if any of the absolute values exceeds the reference value.

9. The apparatus of claim 8, wherein the fault diagnosing unit is arranged to determine the seriousness of the fault based on the amount by which the absolute value exceeds the reference value.

10. The apparatus of claim 7, 8 or 9, wherein the reference value comprises an initial reference value that is provided to the fault diagnosing unit on initial operation of the apparatus.

11. The apparatus of claim 7 when dependent on claim 3, arranged to:

    multiply the average value by a predetermined coefficient k to generate a scaled average value KAVR|D[x]|;
    compare the scaled average value (KAVR|D[x]|) to the reference value REF; and
    update the reference value with the scaled average value if the scaled average value is greater than the reference value.

12. The apparatus of claim 5, 6, 8 or 9, wherein the fault diagnosing unit is arranged to identify the component data in which the fault occurred based on the presence of the fault.

13. The apparatus of any one of the preceding claims, wherein the component data comprises high frequency component data.

14. An energy storage system comprising a power conversion system for selectively connecting a grid system, a generation system and a battery system, further comprising the apparatus according to any one of the preceding claims for detecting a fault in the battery system.

15. A method for detecting a fault in a battery system (100), comprising:

receiving a voltage signal v(t) from a battery system (100);
digitizing the voltage signal to generate voltage data V[x];
performing discrete wavelet transformation on the voltage data to generate component data $D_j[x]$; and
detecting a fault in the battery system based on the component data.

# FIG. 1

# FIG. 2

FIG. 3

$\Phi_{j,k}(t)$

$\Psi_{j,k}(t)$

# FIG. 4

# FIG. 5

# FIG. 6

# FIG. 7

Down-sampling

# FIG. 8

$A_n$    $D_n$    ...    $D_2$    $D_1$

$\dfrac{f_s}{2^{(n+1)}}$    $\dfrac{f_s}{2^n}$    $\dfrac{f_s}{8}$    $\dfrac{f_s}{4}$    $\dfrac{f_s}{2}$

# FIG. 9A

# FIG. 9B

# FIG. 9C

# FIG. 9D

# FIG. 9E

# FIG. 9F

# FIG. 9G

# FIG. 10A

# FIG. 10B

# FIG. 10C

FIG. 11

| | $|D_1|_{max}$ | $|D_2|_{max}$ | $|D_3|_{max}$ | $|D_4|_{max}$ | $|D_5|_{max}$ | $AVR(|D|)_{max}$ |
|---|---|---|---|---|---|---|
| Value | 1.45581 | 2.06277 | 2.27218 | 3.44343 | 2.10596 | 1.11958 |
| Value/ $AVR(|D|)_{max}$ | 1.30031 | 1.84245 | 2.02949 | 3.07564 | 1.88102 | – |

EP 2 770 336 A2